Europäisches Patentamt

**European Patent Office**

**Office européen des brevets**

(11) Veröffentlichungsnummer: **0 006 565**
**B1**

(12) **EUROPÄISCHE PATENTSCHRIFT**

(45) Veröffentlichungstag der Patentschrift:
**07.01.81**

(51) Int. Cl.³: **G 01 R 15/02**, G 01 R 33/06

(21) Anmeldenummer: **79102005.0**

(22) Anmeldetag: **18.06.79**

(54) **Verfahren und Schaltung zur kontaktlosen Messung von Gleich- und Wechselströmen.**

(30) Priorität: **23.06.78 DE 2827601**

(43) Veröffentlichungstag der Anmeldung:
**09.01.80 Patentblatt 80/1**

(45) Bekanntmachung des Hinweises auf die Patenterteilung:
**07.01.81 Patentblatt 81/1**

(84) Benannte Vertragsstaaten:
**AT BE CH DE FR GB IT NL SE**

(56) Entgegenhaltungen:
**DE-A-2 601 252**
**DE-B-2 719 073**
**DE-C-1 133 819**
**GB-A-1 124 576**
**US-A-3 525 041**

(73) Patentinhaber: **GRUNDIG E.M.V. Elektro-Mechanische Versuchsanstalt Max Grundig, Kurgartenstrasse 37, D-8510 Fürth (DE)**

(72) Erfinder: **Fleissner, Horst, Glogauerweg 6, D-8506 Langenzenn (DE)**
Erfinder: **Leberl, Gerfried, Schwabacher Strasse 282, D-8510 Fürth (DE)**

(74) Vertreter: **Voigt, Günter, Kurgartenstrasse 37, D-8510 Fürth (DE)**

## Verfahren und Schaltung zur kontaktlosen Messung von Gleich- und Wechselströmen

Beschreibung:

Die Erfindung bezieht sich auf ein Verfahren zur kontaktlosen Messung von Gleich- und Wechselströmen gemäss Oberbegriff des Anspruchs 1.

Ein solches Verfahren wird bereits in der deutschen Offenlegungsschrift 27 19 073 vorgeschlagen.

Die kontaktlose Messung von Strömen mit Feldplatten ist allgemein bekannt. Die Feldplatten dienen dabei als magnetisch steuerbare Widerstände; ihre Wirkung ist die eines ohmschen Widerstandes, dessen Widerstand im Magnetfeld zunimmt. Dies gilt in gleicher Weise für beide Polaritäten des Feldes. Bei geeigneter Ausführung ist die Kennlinie R = f (B) mit grosser Genauigkeit symmetrisch. Im unteren Teil der Kennlinie ist ihr Verlauf annähernd quadratisch und wird mit steigender Induktion allmählich linear.

Um in einem Teil mit ausreichender Steilheit oder im linearen Teil arbeiten zu können, müssen die Feldplatten magnetisch vorgespannt werden, und zwar sowohl bei Verwendung einzelner Feldplatten als auch bei Verwendung von Feldplattren in Brückenschaltung.

Für die Induktion B = 0 ergeben sich insofern messtechnische Schwierigkeiten als die Erkennung einer Induktion B = 0 mittels einer Feldplatte wegen des waagerechten Verlaufs der Kennlinie in diesem Bereich nur sehr ungenau möglich ist.

Bei der kontaktlosen Messung von Gleichströmen mittels Kompensation der magnetischen Spannung des zu messenden Stromes in einem Eisenkreis durch die magnetische Spannung eines Kompensationsstromes wurden diese Schwierigkeiten bisher beispielsweise dadurch vermieden, dass man den resultierenden Strom nicht bis zum Erreichen einer Induktion B = 0 kompensierte, sondern einen resultierenden Reststrom fliessen liess. Dieser Reststrom bewirkte die nötige magnetische Vorspannung und wurde beim Messergebnis entsprechend berücksichtigt.

Es war auch bereits bekannt, die sich aus dem waagerechten Verlauf der Feldplatten-Kennlinie im Bereich B = 0 ergebenden geringen Genauigkeiten dadurch zu verbessern, dass durch einen Permanentmagneten eine bestimmte magnetische Vorspannung erzeugt wurde.

Die erwähnten Methoden hatten jedoch entscheidende Nachteile. So konnte bei einem resultierenden Reststrom der relativ grosse Temperaturgang der Feldplatte nur unvollkommen kompensiert werden. Dies führte unvermeidlich zu Fehlmessungen. Ähnliche Probleme ergaben sich bei der Erzeugung einer magnetischen Vorspannung durch einen Permanentmagneten, da dieser nicht ausreichend stabil ist. Schliesslich ging bei den bekannten Verfahren auch die magnetische Vorgeschichte des Eisens sehr stark in das Messergebnis ein.

Gemäss der eingangs erwähnten deutschen Offenlegungsschrift P 27 19 073 wird die Genauigkeit der kontaktlosen Messung von Gleich- und Wechselströmen dadurch verbessert, dass der vorhandenen Induktion eine Induktion wechselnder Richtung überlagert wird, und die der jeweiligen Gesamtinduktion zugehörigen Ausgangsgrössen der Feldplatte verglichen werden.

Dieses Verfahren eignet sich sowohl für grosse als auch – durch die sehr gute Nullpunktstabilität – für kleine Ströme.

Um mit kleinen Kompensationsströmen arbeiten zu können, muss die Windungszahl der Kompensationswicklung entsprechend gross gewählt werden, was zu grossen Induktivitäten führt, wodurch dann natürlich die Grenzfrequenz beschränkt wird. Bei Batteriebetrieb ist darüber hinaus der Leistungsbedarf für die Kompensation von Nachteil. Auch ändert sich bei dem vorgeschlagenen Verfahren die Empfindlichkeit der Messung in Abhängigkeit von der Temperatur.

Der Erfindung liegt die Aufgabe zugrunde, ein Verfahren zur kontaktlosen Messung von Gleich- und Wechselströmen zu schaffen, bei dem sich eine Kompensation des Messtromes erübrigt und das unabhängig von der jeweils herrschenden Temperatur seine Messempfindlichkeit beibehält.

Die Lösung dieser Aufgabe erfolgt durch die im kennzeichnenden Teil des Anspruchs 1 angegebenen Massnahmen.

Vorteilhafte Weiterbildungen ergeben sich aus den Unteransprüchen.

Die Erfindung wird nachfolgend unter Bezugnahme auf die Zeichnungsfiguren beispielsweise erläutert. Es zeigen:

Fig. 1 ein Diagramm mit dem Verlauf der Feldplattenspannung in Abhängigkeit vom jeweiligen Magnetisierungsstrom,

Fig. 2 zwei zugeordnete Diagramme des Magnetisierungsstromes und der Feldplattenspannung in Abhängigkeit von der Zeit und

Fig. 3 ein Blockschaltbild einer Schaltungsanordnung zur Durchführung des erfindungsgemässen Verfahrens.

Das erfindungsgemässe Verfahren arbeitet ebenso wie das bereits früher vorgeschlagene Kompensations-Messverfahren mit einem Feldplattensensor.

Die Spannung $U_{FP}$ an der Feldplatte 17 im quadratischen Teil der Kennlinie lässt sich wie folgt beschreiben:

$$(1) \quad U_{FP} = I_{St} \cdot (a \cdot b \cdot B^2 + c \cdot R_0)$$

wobei $U_{FP}$ die Feldplattenspannung, $I_{St}$ der Steuerstrom für die Feldplatte, a der Temperaturfaktor der Magnetfeldabhängigkeit des Feldplattenwiderstandes, b die Empfindlichkeit der Feldplatte (Ohm/$B^2$), c der Temperaturfaktor des Grundwiderstandes und $R_0$ der Grundwiderstand der Feldplatte sind.

In einem ausreichend grossen und konstanten Luftspalt 11 ist die Induktion B hinreichend linear mit dem Induktionsstrom I verknüpft. Die Formel für die Spannung an der Feldplatte 17 lautet dann unter der vereinfachenden Voraussetzung, dass alle Teilströme durch die gleiche Spule fliessen:

$$(2) \quad U_{FP} = I_{St} \cdot (a \cdot d \cdot I^2 + c \cdot R_0)$$

wobei d die Empfindlichkeit der Feldplatte (Ohm/$I^2$) bei einer bestimmten Windungszahl, einem bestimmten Luftspalt und einem bestimmten Steuerstrom $I_{St}$ ist.

Die oben getroffene vereinfachende Annahme, dass alle Ströme durch nur eine einzige Spule fliessen, wird auch bei den nachfolgenden Gleichungen zugrundegelegt, weil sich dadurch – wie bereits erwähnt – die mathematischen Zusammenhänge einfacher darstellen lassen. In der Praxis wird jedoch abweichend hiervon zumindest für den Messtrom $I_m$ eine gesonderte Spule verwendet, die im allgemeinen nur eine einzige Windung aufweist. Vor Addition der Teilströme zum Gesamtstrom I gemäss den Gleichungen sind daher die an sich bekannten Umrechnungen unter Berücksichtigung der Windungszahlen der einzelnen Spulen vorzunehmen.

Der Strom I setzt sich zusammen aus einem Vormagnetisierungsstrom $I_0$ und dem Messtrom $I_m$. Bei Verwendung von symmetrisch zum Nullpunkt liegenden Vormagnetisierungsströmen $\pm I_0$ gilt dann für den Gesamtstrom

$$(3) \quad I = I_m \pm I_0.$$

Unter Heranziehung der weiter oben angeführten Gleichung (2) ergibt sich

$$(4) \quad U_{FP} = I_{St} (a \cdot d \cdot (I_0 + I_m)^2 + c \cdot R_0)$$

für den einen Abtastpunkt und

$$(5) \quad U_{FP} = I_{St} \cdot (a \cdot d \cdot (-I_0 + I_m)^2 + c \cdot R_0)$$

für den anderen Abtastpunkt. Die daraus zu bildende Differenzspannung ergibt sich zu

$$(6) \quad U_D = I_{St} \cdot a \cdot d \cdot 4 \cdot I_0 \cdot I_m.$$

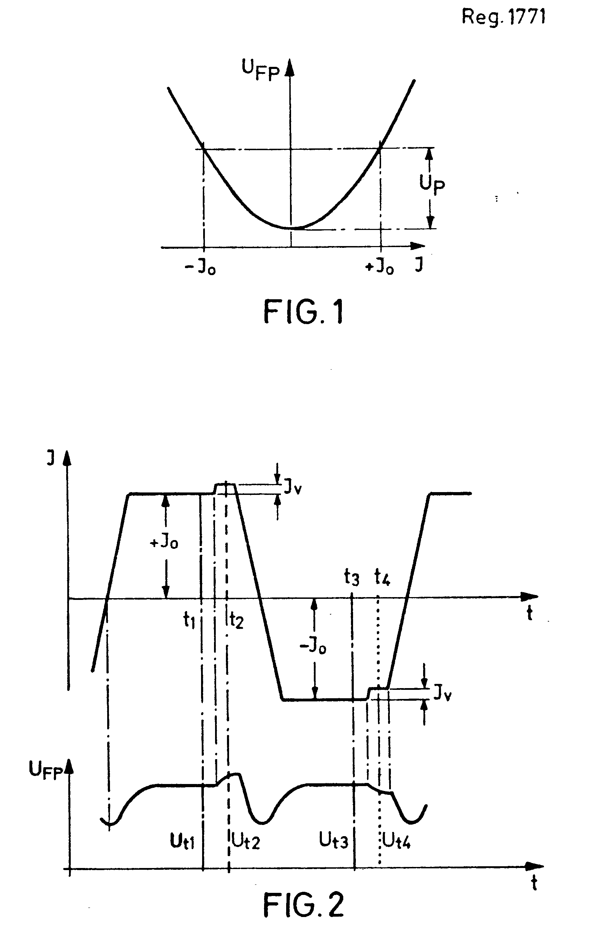

Die Grössen c und $R_0$ sind in der Gleichung nicht mehr enthalten. Die so gewonnene Differenzspannung $U_D$ ist vom Grundwiderstand $R_0$ der Feldplatte und dem zugehörigen Temperaturfaktor c nicht mehr abhängig; sie ist vielmehr linear abhängig vom Messtrom $I_m$, vom Vormagnetisierungstrom $I_0$ und vom Steuerstrom $I_{St}$ der Feldplatte 17. Darüber hinaus ist aber auch eine temperatur- und bauartbedingte Abhängigkeit der Empfindlichkeit der Feldplatte 17 gegeben. Die relativ grosse Temperaturabhängigkeit der Feldplatte 17 ist häufig von erheblichem Nachteil, der – wie nachfolgend im einzelnen erläutert wird – erfindungsgemäss dadurch behoben wird, dass das temperaturbedingte Abdriften der Kennlinie $U_{FP}$ = f (I) gemäss Fig. 1 bei konstantem Steuerstrom $I_{St}$ durch Vergleich der jeweiligen Ist-Werte bestimmter vorgegebener Punkte der Kennlinie mit den zugehörigen Soll-Werten erfasst und durch entsprechende Beeinflussung des Steuerstromes $I_{St}$ bzw. des Vormagnetisierungsstromes $I_0$ derart ausgeregelt wird, dass die Kurve gemäss Fig. 1 auch bei sich verändernden Temperaturen ihre Lage und Form bezogen auf $I_m$ beibehält. Dies geschieht dadurch, dass entweder der Steuerstrom $I_{St}$ oder der Vormagnetisierungsstrom $I_0$ mit dem Faktor $\frac{1}{a}$ multipliziert wird. Hierzu kann eine praktisch kontinuierliche Regelung verwendet werden, bei der der Steuerstrom $I_{St}$ und/oder $I_0$ derart gesteuert werden, dass die Form des quadratischen Teils der Feldplattenkennlinie stets konstant bleibt. Der quadratische Teil der Feldplattenkennlinie ist für den Messvorgang dann als temperaturkonstant anzusehen, wenn am Abtastpunkt $I_0$ stets die gleiche sogenannte Parabelspannung $U_P$ auftritt.

Die Parabelspannung $U_P$ als Ist-Wert wird zu diesem Zweck mit einem konstanten Soll-Wert verglichen. Mit der sich aus dem Vergleich ergebenden Regelabweichung werden $I_{St}$ und/oder $I_0$ entsprechend geregelt.

Sofern die Temperaturänderung langsam verläuft, genügt ein Abgleich in den Messpausen und Speicherung des dabei erreichten Zustandes. Die sich als Differenz ergebende Parabelspannung $U_P$ wird dadurch erhalten, dass die Spannung am tiefsten Punkt der Kennlinie mit einem Minimalwertspeicher, die sich bei den Vormagnetisierungsströmen $+I_0$ und $-I_0$ ergebenden Spannungen mit Maximalwertspeichern erfasst und dann die Differenzen zum bereits vorher erfassten Minimalwert gebildet werden.

In vielen Fällen ist jedoch – anders als oben beschrieben – nicht nur in den Messpausen, sondern praktisch kontinuierlich eine Beseitigung der temperaturabhängigen Veränderungen der Kennlinie wünschenswert. Ein dazu erforderlicher – praktisch kontinuierlicher – Ist-Wert kann dadurch gewonnen werden, dass zu bestimmten Zeiten ein konstanter und bekannter Vergleichsstrom $I_v$ zusätzlich zum Messtrom $I_m$ fliesst. Dabei muss mit zwei zusätzlichen Speichern der Augenblickswert der Feldplattenspannung bei $I_0$ (ohne zusätzlichen Vergleichsstrom $I_v$) und bei Vorhandensein des zusätzlichen Vergleichsstromes $I_v$ erfasst und die Differenz gebildet werden. Die sich dabei ergebende Spannung ergibt sich ausgehend von der Gleichung (6), indem dort der Messtrom $I_m$ durch die Summe aus Messtrom $I_m$ und Vergleichsstrom $I_v$ ersetzt wird.

$$(7) \quad U_{DV} = I_{St} \cdot a \cdot d \cdot 4 \cdot I_0 \cdot (I_m + I_v)$$

Wird nunmehr die Differenz aus der Gleichung (6) – ohne Vergleichsstrom – und der Gleichung (7) – mit Vergleichsstrom – gebildet, so erhält man eine zwar vom Vergleichsstrom $I_v$, aber nicht mehr vom Messtrom $I_m$ abhängige Vergleichsspannung.

$$(8) \quad U_v = U_{DV} - U_D = I_{St} \cdot a \cdot d \cdot 4 \cdot I_0 \cdot I_v$$

Wie sich aus Fig. 2 entnehmen lässt, wird der stets in gleicher Richtung fliessende Vergleichsstrom $I_V$ dem sowohl in positiver als auch in negativer Richtung fliessenden Vormagnetisierungsstrom $I_0$ einmal hinzugefügt und ein anderes Mal von ihm subtrahiert. Der zugehörige Verlauf der Feldplattenspannung $U_{FP}$ ist dem unteren Diagramm der Fig. 2 zu entnehmen. Durch die Speicherung von nur vier Spannungs-Augenblickswerten $U_{t1}$ bis $U_{t4}$ zu den Zeitpunkten $t_1$ bis $t_4$ und drei Differenzbildungen kann die Vergleichsspannung $U_v$ erhalten werden. Sie liefert den benötigten Ist-Wert für die Regelung, ist ständig verfügbar und nicht vom Messtrom $I_m$ abhängig.

Das Diagramm der Fig. 2 lässt erkennen, dass die Vergleichsspannung $U_v$ auch folgendermassen dargestellt werden kann:

(9)    $U_v = (U_{t2} - U_{t4}) - (U_{t1} - U_{t3})$

(9a)    $U_v = U_{t2} + U_{t3} - U_{t1} - U_{t4}$

Der Wert der jeweiligen Vergleichsspannung $U_v$ ist mit nur einem einzigen Operationsverstärker darstellbar.

Eine weitere Möglichkeit zur Gewinnung einer Vergleichsspannung besteht darin, dass die Vormagnetisierungsströme zu bestimmten Zeiten um einen bestimmten vorgegebenen Betrag periodisch erhöht bzw. erniedrigt werden.

Werden die bei den Vormagnetisierungsströmen $+I_0$ und $-I_0$ erhaltenen Spannungen addiert, so erhält man durch Summierung der Gleichungen (4) und (5) eine Summenspannung $U_S$.

(10)    $U_s = 2 \cdot I_{St} \cdot [a \cdot d \cdot (I_0^2 + I_m^2) + c \cdot R_0]$

Der sich dabei ergebende Spannungsverlauf enthält einen quatratischen Anteil, der auch bei unterschiedlich grossem Vormagnetisierungsstrom $I_0$ gleichartig vom Messtrom $I_m$ abhängig ist. Wird die Differenz zweier Summenspannungen erzeugt, die bei unterschiedlichem Vormagnetisierungsstrom $I_0$ gewonnen wurden, so ist diese Spannung vom Messtrom $I_m$ nicht mehr abhängig. Entsprechendes ergibt sich aus den nachfolgenden Gleichungen.

(10a)    $U_{VS} = U_{S1}$ (bei $I_{01}$) $- U_{S2}$ (bei $I_{02}$)

Dabei sind $U_{VS}$ die Vergleichssummenspannung, $U_{S1}$ die sich ergebende Spannung bei einem ersten Vormagnetisierungsstrom $I_{01}$ und $U_{S2}$ die sich ergebende Spannung bei einem zweiten Vormagnetisierungsstrom $I_{02}$.

Im Hinblick auf Gleichung (10) ergibt sich die Vergleichssummenspannung zu

(10b)    $U_{VS} = 2 \cdot I_{St} \cdot [a \cdot d \cdot (I_{01}^2 + I_m^2) + c \cdot R_0]$
$-2 \cdot I_{St} \cdot [a \cdot d \cdot (I_{02}^2 + I_m^2) + c \cdot R_0]$

Daraus ergibt sich

(11)    $U_{VS} = 2 \cdot a \cdot d \cdot I_{St} \cdot (I_{01}^2 - I_{02}^2)$

In dieser Gleichung tritt der Messtrom $I_m$ nicht mehr auf. Die Vergleichssummenspannung ist somit unabhängig vom Messtrom $I_m$ konstant, wenn die Vormagnetisierungsströme $I_{01}$ und $I_{02}$ jeweils konstant sind und sich der Steuerstrom $I_{St}$ der Feldplatte 17 zur Kompensation der Temperatureinflüsse so ändert, dass das Produkt aus Steuerstrom $I_{St}$ und dem Temperaturfaktor a konstant bleibt. Diese Tatsache lässt sich für eine Regelung verwenden, wenn die sich ergebende Vergleichssummenspannung $U_{VS}$ mit einem Soll-Wert verglichen und die Regelabweichung zur Steuerung des Steuerstromes $I_{St}$ der Feldplatte benutzt wird.

Da der Steuerstrom der Feldplatte durch eine solche Regelung praktisch einen temperaturkorrigierenden Faktor $\frac{1}{a}$ erhält, wird nach Gleichung (6) die Messspannung $U_D$ temperaturkonstant, denn die temperaturabhängige Korrektur des Steuerstromes $I_{St}$ wirkt sich dort ebenfalls aus.

Der zeitliche Ablauf für den Strom I und die Feldplattenspannung $U_{FP}$ sind auch hier ähnlich wie bereits in Fig. 2 dargestellt. Zu den Zeiten $t_1$ und $t_3$ ist jedoch der Vormagnetisierungsstrom $I_{01}$ und zu den Zeiten $t_2$ und $t_4$ der Vormagnetisierungsstrom $I_{02}$ anzusetzen. Die vier Augenblickswerte der Feldplattenspannung zu den Zeiten $t_1$ bis $t_4$ ergeben

(12)    $U_{VD} = (U_{t1} + U_{t3}) - (U_{t2} + U_{t4})$

(12a)    $U_{VD} = U_{t1} + U_{t3} - U_{t2} - U_{t4}$

Auch diese Spannung $U_{VD}$ kann mit nur einem einzigen Operationsverstärker dargestellt werden.

Wie bereits eingangs erwähnt wurde, stellt der Faktor d die Empfindlichkeit der Feldplatte in einem Eisenkreis mit einem bestimmten Luftspalt sowie mit einer Spule mit bestimmten Windungszahlen dar, wobei die Windungen von den Strömen $I_0$ (Vormagnetisierungsstrom), $I_m$ (Messtrom) und ggf. $I_V$ (Vergleichsstrom) durchflossen werden.

Da sich bei einer Änderung der Empfindlichkeit d ($Ohm/I^2$) infolge Änderung der Grösse des Luftspalts ebenfalls Abweichungen zwischen Ist-Werten und Soll-Werten der Spannung ergeben, die dann über die beschriebene Regelung ausregelbar sind, können mit Hilfe dieser Regelung auch Änderungen des Luftspaltes oder durch Fertigungstoleranzen bedingte Unterschiede der Luftspalte ausgeglichen werden. Das beschriebene Verfahren bietet daher den Vorteil, dass Magnetkreis mit Spulen und Feldplatte (die eigentliche Stromzange) und Steuerschaltung als zwei getrennte Gruppen beliebig kombiniert werden können, wodurch eine Modulisierung der Teilschaltungen möglich ist. Dies vereinfacht einen Austausch von Teilen der Gesamtanordnung im Reparaturfall ganz erheblich. Voraussetzung ist lediglich, dass die Windungszahlen der Spulen gleich sind. Luftspalt und Feldplattenempfindlichkeit dürfen jedoch jeweils in bestimmten Grenzen variieren.

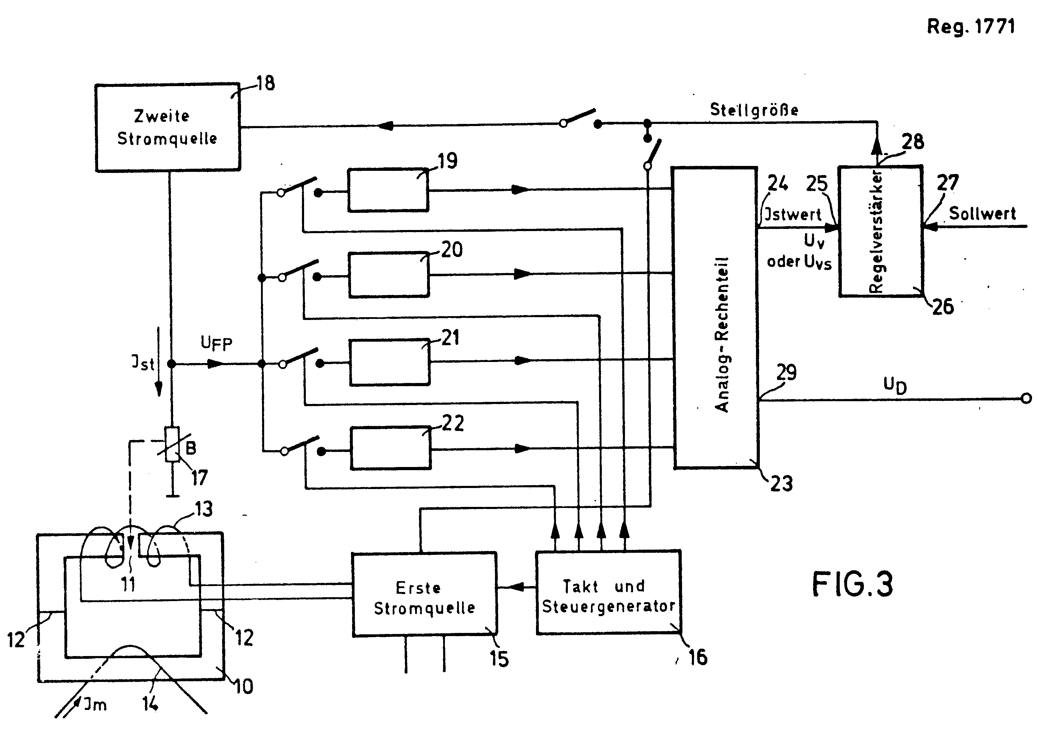

Nachfolgend wird eine Schaltungsanordnung zur Durchführung des erfindungsgemässen Verfahrens anhand der Fig. 3 im einzelnen beschrieben. Ein Eisenkreis 10 mit Luftspalt 11 und einer an geeigneter Stelle angeordneten Trennfuge 12 weist einmal eine Vormagnetisierungsspule 13 und zum anderen eine Messpule 14 auf, die im einfachsten Fall aus einem vom Messtrom durchflossenen und durch den Eisenkreis hindurchgeführten Leiter, d.h. aus einer Spule mit einer einzigen Windung, besteht. Die Vormagnetisierungsspule 13 wird durch eine erste Stromquelle 15, die durch einen Takt- und Steuergenerator 16 gesteuert wird, mit einem vorgegebenen Strom versorgt. Eine Feldplatte 17 ist im Luftspalt 11 des Eisenkreises 10 angeordnet. Sie wird über eine zweite gesteuerte Stromquelle 18 mit Strom versorgt. Der sich infolge dieses Stromes einstellende Spannungsabfall $U_{FP}$ an der Feldplatte 17 wird zu bestimmten vorgegebenen Zeiten, die durch den Takt- und Steuergenerator 16 vorgegeben werden, in Speichern 19 bis 22 erfasst und an einen Analog-Rechenteil 23 weitergeleitet, der zwei Ausgänge 24, 29 aufweist. Am ersten Ausgang 24 steht der gemäss den weiter oben angegebenen Gleichungen ermittelte Ist-Wert für $U_V$ bzw. $U_{VS}$ an, der einem Ist-Wert-Eingang 25 eines Regelverstärkers 26 zugeführt wird. In diesem Regelverstärker 26 wird nach Vergleich mit einem am Soll-Wert-Eingang 27 anstehenden Soll-Wert eine Regelabweichung festgestellt, die eine bestimmte Stellgrösse am Ausgang 28 des Regelverstärkers 26 zur Folge hat und die von diesem geregelte zweite Stromquelle 18 beeinflusst. Über die Stellgrösse wird der Steuerstrom $I_{St}$ der Feldplatte 17 derart ausgeregelt, dass Temperatureinflüsse das Messergebnis nicht mehr beeinträchtigen können. Der zweite Ausgang 29 des Analog-Rechenteils 23 liefert die Spannung $U_D$, die gemäss Gleichung (6) eine – durch die Regelung temperaturunabhängige – Aussage über den Messtrom $I_m$ ermöglicht.

Ein etwaiges Öffnen des Eisenkreises 10 erfolgt vorteilhafterweise durch Aufklappen des Eisenkerns 10 an der Trennfuge 12. Der Messleiter 14 lässt sich dann bequem in den Eisenkreis 10 einführen.

Etwa vorhandene Störeinflüsse durch Fremdfelder können durch Verwendung zweier Feldplatten – wie im DE-GM 75 27 185 für Hallgeneratoren beschrieben – ausgeschaltet werden.

## Patentansprüche

1. Verfahren zur kontaktlosen Messung von Gleich- und Wechselströmen unter Verwendung eines Eisenkerns (10) mit Luftspalt (11) mit einer von einem Steuerstrom ($I_{St}$) durchflossenen Feldplatte (17) und mindestens einer von einem Messtrom ($I_m$) durchflossenen Spule (14), dadurch gekennzeichnet, dass mindestens eine weitere Spule (13) auf dem Eisenkern (10) angeordnet ist und von einem Vormagnetisierungsstrom ($I_0$) durchflossen wird, wobei die Durchflutung in kurzen zeitlichen Abständen in genau definiertem Masse verändert wird, die sich dabei ergebenden Ist-Änderungen der Feldplattenspannung mit Soll-Änderungen verglichen und sich etwa ergebende Abweichungen durch Änderung des Steuerstromes ($I_{St}$) der Feldplatte (17) oder des Vormagnetisierungsstromes ($I_0$) ausgeregelt werden.

2. Verfahren nach Anspruch 1, dadurch gekennzeichnet, dass die Änderung der Feldplattenspannung bei einem bestimmten Vormagnetisierungsstrom ($I_0$) gegenüber dem Vormagnetisierungsstrom Null als Ist-Änderung gewählt wird.

3. Verfahren nach Anspruch 1, dadurch gekennzeichnet, dass die Änderung der Feldplattenspannung bei Vorhandensein eines zusätzlichen Vergleichsstromes ($I_v$) gegenüber der Feldplattenspannung bei dessen Abwesenheit als Ist-Änderung gewählt wird.

4. Verfahren nach Anspruch 1, dadurch gekennzeichnet, dass die Änderung der Feldplattenspannung bei einer durch einen ersten Vormagnetisierungsstrom ($I_{01}$) bewirkten Durchflutung gegenüber einer hiervon um einen bestimmten Betrag abweichenden, durch einen zweiten Vormagnetisierungsstrom ($I_{02}$) bewirkten Durchflutung als Ist-Abweichung gewählt wird.

5. Verfahren nach einem der Ansprüche 1 bis 4, dadurch gekennzeichnet, dass die Änderung der Durchflutung durch Änderung der massgeblichen Spulen-Windungszahlen erreicht wird.

6. Schaltungsanordnung zur Durchführung des Verfahrens nach einem der Ansprüche 1 bis 5, dadurch gekennzeichnet, dass ein wenigstens mit einer Messpule (14) und einer Vormagnetisierungsspule (13) versehener magnetischer Eisenkreis (10) mit Luftspalt (11) vorhanden ist, dass die Vormagnetisierungsspule (13) von einer gesteuerten ersten Stromquelle (125) mit Strom versorgt wird, die ihrerseits durch einen Takt- und Steuergenerator (16) beeinflussbar ist, dass darüber hinaus eine zweite, den durch eine im Eisenkreis (10) angeordnete Feldplatte (17) fliessenden Steuerstrom ($I_{St}$) beeinflussende Stromquelle (18) vorhanden ist, und der infolge Änderung der magnetischen Induktion sich an der Feldplatte (17) einstellende Spannungsabfall ($U_{FP}$) zu bestimmten vorgegebenen Zeiten in Speichern (19 bis 22) erfasst und einem Analog-Rechenteil (23) zugeführt wird, dessen Ausgang (24) mit einem Eingang (25) eines Regelverstärkers (26) verbunden ist, wobei einem zweiten Eingang (27) des Regelverstärkers (26) ein Soll-Wert zuführbar ist und der Ausgang (28) des Regelverstärkers (26) mit der von ihm geregelten zweiten Stromquelle (18) für die Feldplatte (17) und/oder der ersten Stromquelle (15) für den Vormagnetisierungsstrom verbunden ist.

7. Schaltungsanordnung nach Anspruch 6, dadurch gekennzeichnet, dass der Eisenkreis (10) zu öffnen ist.

## Claims

1. A method of measuring DC and AC currents without the use of contacts by using an iron core (10) provided with an air gap (11), comprising a field plate (17) through which a control current $(I_{St})$ flows and at least one winding (14) through which a measuring current $(I_m)$ flows, characterised in that, at least one further winding (13), through which a pre-magnetising current $(I_0)$ flows, is arranged on the iron core (10) wherein the through flow is varied at short time intervals to an accurately defined extent, the actual variations of the field plate voltage thus produced are compared with the desired-variations and any deviations which occur are corrected by varying the control current $(I_{St})$ in the field plate (17) or the pre-magnetising current $(I_0)$.

2. A method according to claim 1, chracterised in that, the variation of the field plate voltage at a predetermined pre-magnetising current $(I_0)$ with respect to the zero pre-magnetising current is selected as an actual-variation.

3. A method according to claim 1, characterised in that, the variation of the field plate voltage in the presence of an additional comparison current $(I_v)$ with respect to the field plate voltage in its absence is selected as an actual-variation.

4. A method according to claim 1 characterised in that, the variation of the field plate voltage with a through flow effected by a first pre-magnetising current $(I_{01})$ with respect to a through flow deviating therefrom by a predetermined amount and effected by a second pre-magnetising current $(I_{02})$ is selected as an actual deviation.

5. A method according to one of claims 1 to 4 characterised in that, the variation in the through flow is produced by varying the definite number of turns in the winding.

6. A circuit arrangement for carrying out the method according to one of claims 1 to 5, characterised in that, at least one magnetic iron circuit (10) with an air gap (11) and provided with a measuring coil (14) and a pre-magnetising coil (13), is provided, but the pre-magnetising coil (13) is supplied with current from a controlled first current source (15) which in its turn can be influenced by a clock and control generator (16) that, moreover, a second current source (18) is provided influencing the control current $(I_{St})$ flowing through a field plate (17) arranged in the iron circuit (10), and which, as a result of variation of the magnetic induction, logs a voltage drop $(U_{FP})$ appearing at the field plate (17) in stores (19–22) at specific predetermined times and is transmitted to an analog computer unit (23) the output (24) from which is connected to one input (25) to a control amplifier (26) wherein a set value can be transmitted to a second input (27) to the control amplifier (26) and the output (28) from the control amplifier (26) is connected to the second current source (18) for the field plate (17) controlled by the amplifier and/or through the first current source (15) for the pre-magnetising current.

7. A circuit arrangement according to claim 6, characterised in that, the iron circuit (10) is arranged to be broken.

## Revendications

1. Procédé pour la mesure sans contact de courants continus et alternatifs par utilisation d'un noyau en fer (10) comportant un entrefer (11), un détecteur de champ (17) parcouru par un courant de commande $(I_{St})$ et au moins une bobine (14) parcourue par un courant à mesurer $(I_m)$, caractérisé en ce qu'au moins une autre bobine (13) est montée sur le noyau en fer (10) et parcourue par un courant de prémagnétisation $(I_0)$, le flux est modifié dans une mesure définie avec précision à brefs intervalles de temps, les variations réelles de la tension du détecteur de champ qui se forment alors sont comparées à des variations de consigne et les écarts produits éventuellement sont compensés par modification du courant de commande $(I_{St})$ du détecteur de champ (17) ou du courant de prémagnétisation $(I_0)$.

2. Procédé suivant la revendication 1, caractérisé en ce que la modification de la tension du détecteur de champ pour un courant de prémagnétisation donné $(I_0)$ par rapport au courant de prémagnétisation nul est choisie comme variation réelle.

3. Procédé suivant la revendication 1, caractérisé en ce qu'on choisit comme variation réelle la variation de la tension du détecteur de champ en présence d'un courant de comparaison additionnel $(I_v)$ par rapport à la tension du détecteur de champ en l'absence de ce courant.

4. Procédé suivant la revendication 1, caractérisé en ce qu'on choisit comme écart réel la variation de la tension du détecteur de champ en présence d'un flux engendré par un premier courant de prémagnétisation $(I_{01})$ par rapport à un flux différent du premier dans une certaine mesure et engendré par un deuxième courant de prémagnétisation $(I_{02})$.

5. Procédé suivant l'une des revendications 1 à 4, caractérisé en ce que la modification du flux est obtenue par modification des nombres de spires des bobines.

6. Circuit pour la mise en œuvre du procédé suivant l'une des revendications 1 à 5, caractérisé en ce qu'il comprend au moins un circuit magnétique (10) présentant un entrefer (11) et muni d'au moins une bobine de mesure (14) et d'une bobine de prémagnétisation (13), en ce que la bobine de prémagnétisation (13) est alimentée en courant par une première source de courant commandé (15) qui est de son côté influencée par un générateur d'horloge et de commande (16), en ce que, en outre, il est prévu une deuxième source de courant (18) influençant le courant de commande $(I_{St})$ qui circule dans un détecteur de champ (17) monté dans le circuit magnétique (10) et la chute de tension $(U_{St})$ qui apparaît sur le détecteur de champ (17) par suite d'une modification de l'induction magnétique est captée à certains instants prédéterminés dans des mémoires (19 à 22) et transmise à une zone (23) de calcul analogique dont la sortie (24) est reliée à une entrée (25) d'un amplificateur régulateur (26), une valeur de consigne pouvant être transmise à une deuxième entrée (27) de l'amplificateur régulateur (26) et la sortie (28) de l'amplificateur régulateur (26) est reliée à la deuxième source de courant (18) réglée par cet amplificateur et servant à alimenter le détecteur de champ (17) et/ou à la première source de courant (15) qui fournit le courant de prémagnétisation.

7. Circuit suivant la revendication 6, caractérisé en ce que le circuit magnétique (10) peut être ouvert.

0 006 565

Reg. 1771

FIG. 1

FIG. 2

FIG.3